# EUROPÄISCHE PATENTSCHRIFT

(11) **EP 1 424 708 B1**
(45) Veröffentlichungstag und Bekanntmachung des Hinweises auf die Patenterteilung: **28.12.2005**
(21) Anmeldenummer: 03023309.2
(22) Anmeldetag: 15.10.2003
(51) Int. Cl.: H01G 9/06, H01G 9/08, H01G 9/12, H01G 2/06

(54) **Anordnung mit mindestens einem Kondensator**
Asembly with at least one capacitor
Ensemble avec au moins un condensateur

(30) Priorität: 29.11.2002 DE 20218520 U
(43) Veröffentlichungstag der Anmeldung: 02.06.2004
(73) Patentinhaber: ebm-papst Mulfingen GmbH & Co.KG, 74673 Mulfingen (DE)
(72) Erfinder: Sauer, Thomas, 65610 Idstein (DE); Lipp, Helmut, 74677 Dörzbach-Hohebach (DE); Zierlein, Rainer, 97999 Igersheim (DE); Heer, Thomas, 97947 Grünsfeld (DE)
(74) Vertreter: Patentanwälte Dr. Solf & Zapf

(56) Entgegenhaltungen:
- US-A- 4 363 078
- US-A- 4 480 289
- PATENT ABSTRACTS OF JAPAN vol. 2000, no. 25, 12. April 2001 (2001-04-12) & JP 2001 223130 A (MATSUSHITA ELECTRIC IND CO LTD), 17. August 2001 (2001-08-17)
- PATENT ABSTRACTS OF JAPAN vol. 016, no. 204 (E-1202), 15. Mai 1992 (1992-05-15) & JP 04 033321 A (MATSUSHITA ELECTRIC IND CO LTD), 4. Februar 1992 (1992-02-04)
- PATENT ABSTRACTS OF JAPAN vol. 2000, no. 04, 31. August 2000 (2000-08-31) -& JP 2000 030981 A (ELNA CO LTD), 28. Januar 2000 (2000-01-28) -& JP 2000 030981 A (ELNA CO LTD) 28. Januar 2000 (2000-01-28)
- PATENT ABSTRACTS OF JAPAN vol. 017, no. 538 (E-1440), 28. September 1993 (1993-09-28) & JP 05 152162 A (FUJITSU GENERAL LTD), 18. Juni 1993 (1993-06-18)
- PATENT ABSTRACTS OF JAPAN vol. 1999, no. 05, 31. Mai 1999 (1999-05-31) & JP 11 040468 A (FUJI ELELCTROCHEM CO LTD), 12. Februar 1999 (1999-02-12)
- PATENT ABSTRACTS OF JAPAN vol. 1998, no. 10, 31. August 1998 (1998-08-31) & JP 10 144568 A (TOSHIBA ENG CO LTD), 29. Mai 1998 (1998-05-29)

## Beschreibung

Die Erfindung betrifft eine Anordnung mit einer mindestens einen Kondensator, insbesondere Elektrolytkondensator, aufweisenden elektronischen Schaltung, die einen Bauteilträger mit stromführenden Bahnen, insbesondere eine Leiterplatte, und eine den Kondensator sowie den Bauteilträger vor schädlichen Umgebungseinflüssen, wie Schmutz, Feuchtigkeit und/oder Salznebel, schützenden Vergussmasse aufweist, wobei der Kondensator mit den Leiterbahnen elektrisch verbunden ist. Eine solche Anordnung ist aus JP 2001 22 3130 A bekannt.

In der Kraftfahrzeugtechnik werden elektronische Schaltungen eingesetzt, die durch eine Vergussmasse aus elektrisch isolierendem Material die Schaltung vor Umgebungseinflüssen schützt. Die elektronischen Schaltungen weisen bekanntermaßen Bauteile auf, die auf einer Leiterplatte angeordnet sind. Die Vergussmasse hat vor allem die Aufgabe, die elektrischen Leiterbahnen vor Ablagerungen, wie Schmutz, Feuchtigkeit oder Salznebel zu schützen, damit Kurzschlüsse oder eine sonstige Funktionsbeeinträchtigung der elektronischen Schaltung verhindert wird. Hierbei werden auch Elektrolytkondensatoren von der Vergussmasse eingeschlossen, wobei die gesamte Anordnung in einem schalenartigen Becherteil untergebracht ist. Diese Anordnungen sind häufig in einem Motorraum zu finden, insbesondere in der Nähe von Elektromotoren, da sie Teile einer Steuerung oder Regelung bilden. Auf Grund der auftretenden hohen Betriebstemperaturen können infolge austretender Gase der Elektrolytkondensatoren die Schaltungen jedoch zerstört werden.

Der Erfindung liegt die Aufgabe zu Grunde, eine Anordnung der eingangs genannten Art zu finden, die die Funktion der elektronischen Schaltung auch bei hohen Temperaturen über einen langen Zeitraum sicherstellt.

Diese Aufgabe wird dadurch gelöst, dass der Kondensator in einem von der Vergussmasse teilweise umschlossenen Schutzbecher angeordnet ist, wobei der Schutzbecher zwischen Kondensator und Bauteilträger angeordnet ist.

Die Erfindung beruht auf der Erkenntnis, dass sich bei hohen Temperaturen Elektrolytablagerungen zwischen den Leiterbahnen festsetzen können, die durch ein Ausgasen von Elektrolytkondensatoren entstehen. Diese Elektrolytablagerungen können Kurzschlüsse verursachen, die die Schaltung zerstören.

Versuche haben gezeigt, dass aus den Elektrolytkondensatoren austretende Gase von der Vergussmasse eingeschlossen werden, wobei sie sich dann auf direktem Wege im Schaltungsbereich niederschlagen.

Durch den erfindungsgemäßen Schutzbecher werden durch Ausgasungsvorgänge freigesetzte Elektrolyte von den Leiterbahnen femgehalten. Hierbei kann weiterhin eine in der Vergangenheit besonders bewährte Vergussmasse eingesetzt werden, die die Schaltung zuverlässig schützt. Eine hohe elektrische Belastung des Kondensators ist hierbei möglich.

Der Schutzbecher ist bevorzugt derart ausgebildet und/oder derart angeordnet, dass ein Überdruck - insbesondere infolge eines ausgasenden Elektrolyts - verhindert wird, der zur Beschädigung der Vergussmasse führen kann.

In einer vorteilhaften Weiterbildung der Erfindung ist vorgesehen, dass die Vergussmasse den Schutzbecher nur teilweise umschließt, derart, dass austretende Gase des Kondensators von einem Vergussmassenbereich in einen freien Bereich entweichen können. Hierbei ragt der Kondensator mit seinem Schutzbecher aus der Vergussmasse heraus, wobei dann in vorteilhafter Weise der Schutzbecher aus einem an dem Bauteilträger anliegenden Becherunterteil mit einem Anschlussöffnungen aufweisenden Becherboden, insbesondere aus einem Thermo- oder Duroplast, und einem Verschlussdeckel, insbesondere aus einem Gummimaterial oder Thermo- oder Duroplast besteht, der an dem Becherunterteil form- und/oder kraftschlüssig befestigbar ausgeführt ist. Der Verschlussdeckel verhindert das Eindringen von Schmutz und dergleichen in den Kondensatorbereich. Bei dieser bevorzugten Ausführungsform erfolgt die Montage in einfacher Weise so, dass der Kondensator in den Schutzbecher eingeführt wird, so dass Anschlüsse des Kondensators die Anschlussöffnungen des Becherunterteils durchdringen, und dann der Schutzbecher mit seinem Verschlussdeckel abgedeckt wird. Anschließend wird der Schutzbecher am Bauteilträger befestigt und die Anschlussleitungen des Kondensators mit der Leiterplatte verlötet.

Um ein Austreten der Gase - insbesondere ein ausgasendes Elektrolyt - zu ermöglichen, ohne dass eine Schutzfunktion der Anordnung bezüglich der Umgebungseinflüsse beeinträchtigt wird, ist in vorteilhafter Weise vorgesehen, dass der Verschlussdeckel und/oder das Becherunterteil mindestens eine Öffnung aufweist und/oder mindestens eine zwischen dem Verschlussdeckel und dem Becherunterteil gebildete Öffnung vorhanden ist, die derart ausgebildet ist (sind), dass sie gasdurchlässig, aber wasser- und schmutzabweisend, insbesondere salznebelabweisend, ist (sind). Hierdurch kann ein Überdruck im Schutzbecher verhindert werden.

Besonders vorteilhaft ist die Verwendung einer Kleberschicht, einer Gummidichtung und/oder einer anderen elastischen Zwischenschicht als Dichtmittel zwischen dem Schutzbecher und dem Bauteilträger. Die Kleberschicht hat eine dreifache Funktion. Die erste ist die Verklebung des Schutzbechers an dem Bauteilträger. Die zweite ist die Verhinderung eines Eintritts von Vergussmasse in einen Innenraum des Schutzbechers während eines Vergießvorgangs. Die dritte ist die Abdichtung bezüglich der austretenden Gase. Bei anderen Dichtmitteln wird die Befestigung des Schutzbechers durch zusätzliche Befestigungsmittel sichergestellt.

Ein zusätzlicher oder alternativer Schutz beim Eindringen von Vergussmasse wird dadurch erreicht, dass der Schutzbecher mindestens einen Abstandshalter - insbesondere bodenseitig an einer Innenfläche des Schutzbechers angeformte Anlagezapfen - aufweist, der derart ausgebildet ist, dass einerseits eine von dem Bauteilträger beabstandete Anordnung einer bodennahen Stirnseite des Kondensators gegeben ist und andererseits die Stirnseite, insbesondere an Stellen einer Ausgasungsgummidichtung des Kondensators, nicht gasdicht abgeschlossen wird. Insbesondere ein Freiraum zwischen der Stirnseite des Kondensators und einer Bodenfläche des Schutzbechers ist für die Entgasung vorteilhaft, wobei ein zu hoher Gasdruck im Bereich der Ausgasungsgummidichtungen wirksam verhindert wird.

Eine vorteilhafte Maßnahme, um sowohl einen Druckanstieg innerhalb eines Vergussmassenbereichs in Folge der Gase zu verhindern, als auch um die Gase wirksam abzuführen, ergibt sich, wenn innerhalb des Schutzbechers senkrecht zum Bauteilträger verlaufende Entgasungswege vorhanden sind, die von einem boden- bzw. anschlussnahen Bereich des Kondensators zu einem freien Bereich ausserhalb der Vergussmasse führen. Insbesondere in Kombination mit am Innenumfang des Schutzbechers angeordneten und jeweils voneinander in Umfangsrichtung beabstandeten Führungsstegen werden von Freiräumen zwischen den Führungsstegen Entgasungskanäle gebildet, wobei eine exakte Einführung des Kondensators in eine für den elektrischen Anschluss erforderliche genaue Position gegeben ist.

Weitere vorteilhafte Weiterbildungen der Erfindung sind in den Unteransprüchen enthalten.

An Hand von bevorzugten Ausführungsbeispielen und der Zeichnungen wird die Erfindung näher erläutert.

Es zeigt:
- Fig. 1: eine Darstellung einer erfindungsgemäßen Anordnung in Verbindung mit einem Elektromotor von der Seite,
- Fig. 2: eine Darstellung gemäß Fig. 1, jedoch von oben,
- Fig. 3: eine Darstellung eines Kondensators in der erfindungsgemäßen Anordnung,
- Fig. 4: eine Darstellung im Wesentlichen gemäß Fig. 3, jedoch unter einem anderen Schnittwinkel dargestellt,
- Fig. 5: eine erste Variante eines erfindungsgemäßen Schutzbechers in Explosionsansicht,
- Fig. 6: eine perspektivische Darstellung des erfindungsgemäßen Schutzbechers nach Fig. 5,
- Fig. 7: eine Explosionsdarstellung des Schutzbechers mit einer anderen Verschlussdeckelvariante,
- Fig. 8: eine perspektivische Darstellung der Ausführungsform nach Fig. 7,
- Fig. 9: eine Darstellung des Schutzbechers von unten,
- Fig. 10: eine Schnittdarstellung des Schutzbechers,
- Fig. 11: eine weitere Schnittdarstellung des Schutzbechers, jedoch aus einem anderen Schnittwinkel,
- Fig. 12: eine Darstellung von oben in das Schutzbecherinnere,
- Fig. 13: eine perspektivische Darstellung des Schutzbechers mit Einblick in das Becherinnere,
- Fig. 14: eine perspektivische Darstellung des Schutzbechers aus einer anderen Perspektive.

In den verschiedenen Figuren der Zeichnungen sind gleiche Teile stets mit denselben Bezugszeichen versehen, so dass sie in der Regel jeweils nur einmal beschrieben werden.

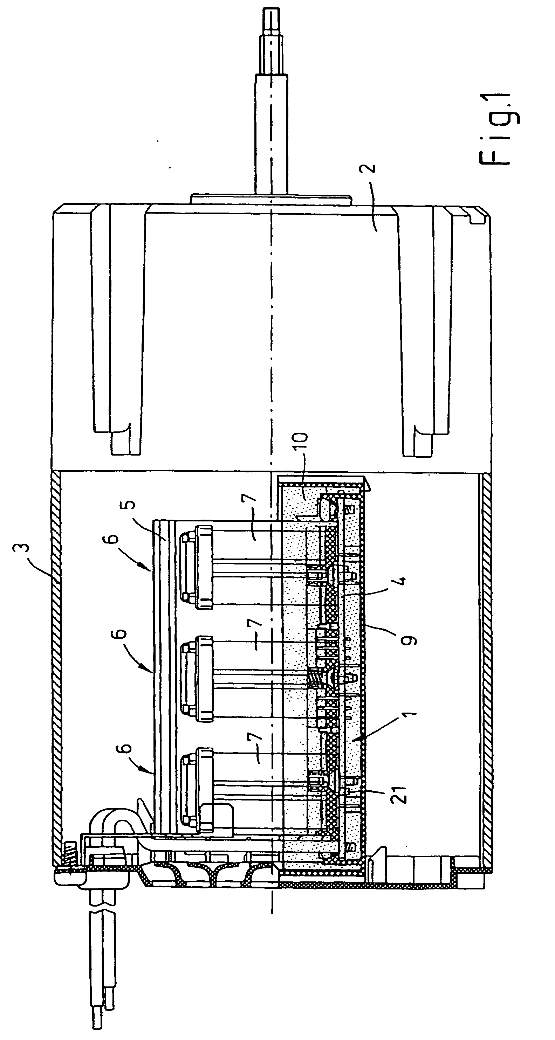

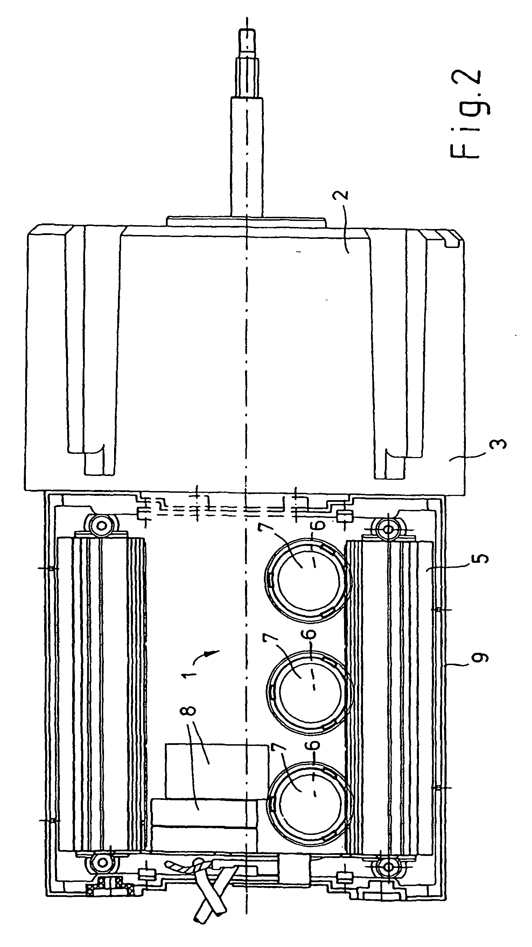

Die Figuren 1 und 2 veranschaulichen eine erfindungsgemäße Anordnung einer elektronischen Schaltung 1 für einen Elektromotor 2, insbesondere für die Kraftfahrzeugindustrie. Der Elektromotor 2 wird vorzugsweise im Motorraum eines Kraftfahrzeuges eingesetzt.

Die elektronische Schaltung 1 ist an einem Motorgehäuse 3 des Elektromotors befestigt und besteht vorzugsweise aus einer Leiterplatte 4 (Bauteilträger), Kühlkörpern 5, mehreren Elektrolytkondensatoren 6, weiteren Bauelementen 8 sowie aus mehreren erfindungsgemäßen Schutzbechern 7, die in einem schalenartigen, die Vergussmasse 10 aufnehmenden Becherteil 9 untergebracht sind.

Die Leiterplatte 4 wird mit einer elektrisch isolierenden Vergussmasse 10 (Fig. 1) umgossen, um insbesondere Leiterbahnen der Leiterplatte 4 vor Umgebungseinflüssen wie Schmutz, Feuchtigkeit und insbesondere Salznebel zu schützen. Durch die Vergussmasse 10 wird aber auch eine mechanisch stabile, insbesondere vibrationssichere Einheit erreicht. Vorzugsweise wird die Vergussmasse 10 so eingesetzt, dass sie jeden Schutzbechert mit darin angeordnetem Elektrolytkondensator 6 nur teilweise umschließt, insbesondere derart, dass jeder Elektrolytkondensator 6 aus der Vergussmasse 10 herausragt.

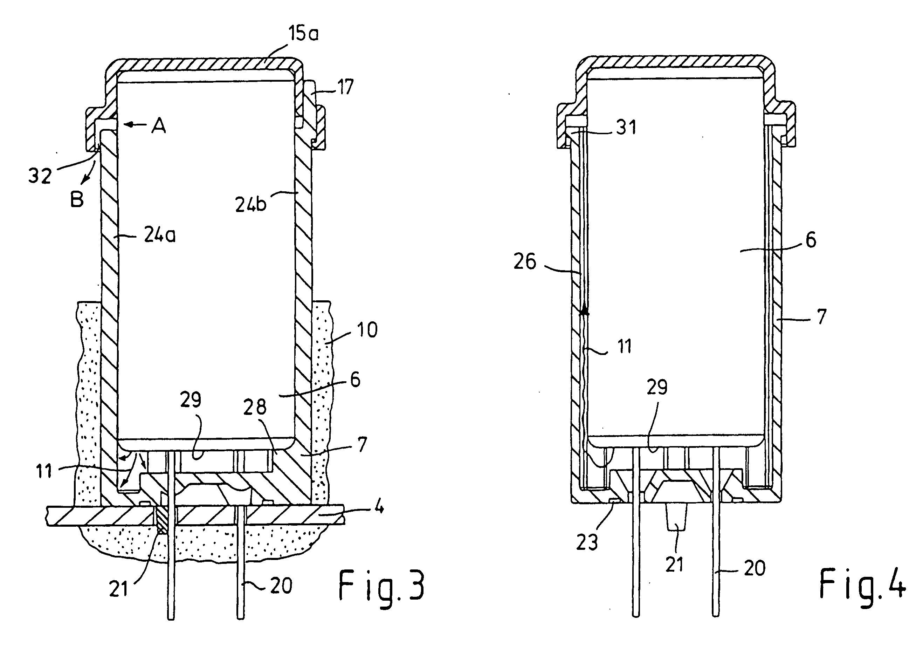

Erfindungsgemäß ist, wie insbesondere in Fig. 3 veranschaulicht ist, der dargestellte Kondensator 6 in dem Schutzbecher 7 angeordnet, wobei der Schutzbecher 7 zwischen Kondensator 6 und Bauteilträger 4 angeordnet ist. Um zu verhindern, dass austretenden Gase 11 (ausgasendes Elektrolyt) (Fig. 3) des Elektrolytkondensators 6 auf Grund einer hohen Temperatur direkt auf die Leiterplatte 4 gelangen, liegt der Schutzbecher 7 erfindungsgemäß - im Prinzip als Gasbarriere - zwischen dem Kondensator 6 und der Leiterplatte 4, wobei insbesondere verhindert werden soll, dass sich die Gase 11 in Form einer Kriechstrecke auf die Bereiche von Leiterbahnen der Leiterplatte 4 festsetzen können. Diese unerwünschten Kriechstrecken können nämlich Kurzschlüsse verursachen, die zum Ausfall der elektronischen Schaltung 1 führen. Praktisch gesehen ist der Schutzbecher 7 zwischen der Vergussmasse 10 und der Leiterplatte 4 angeordnet. Durch diese erfindungsgemäße Anordnung wird erreicht, dass die austretenden Gase 11 nicht unmittelbar in der Vergussmasse 10 eingeschlossen werden und dadurch ungehindert die obengenannten Schäden verursachen können. Die Gase 11 werden zunächst, wie Fig. 3 zeigt, vom Schutzbecher 7 aufgenommen.

Wie die Fig. 4 zeigt, ist der Schutzbecher 7 vorzugsweise derart ausgebildet, dass die Gase 11 in einer von der Leiterplatte 7 wegweisenden Richtung in einen freien Bereich ausserhalb der Vergussmasse 10 entweichen können.

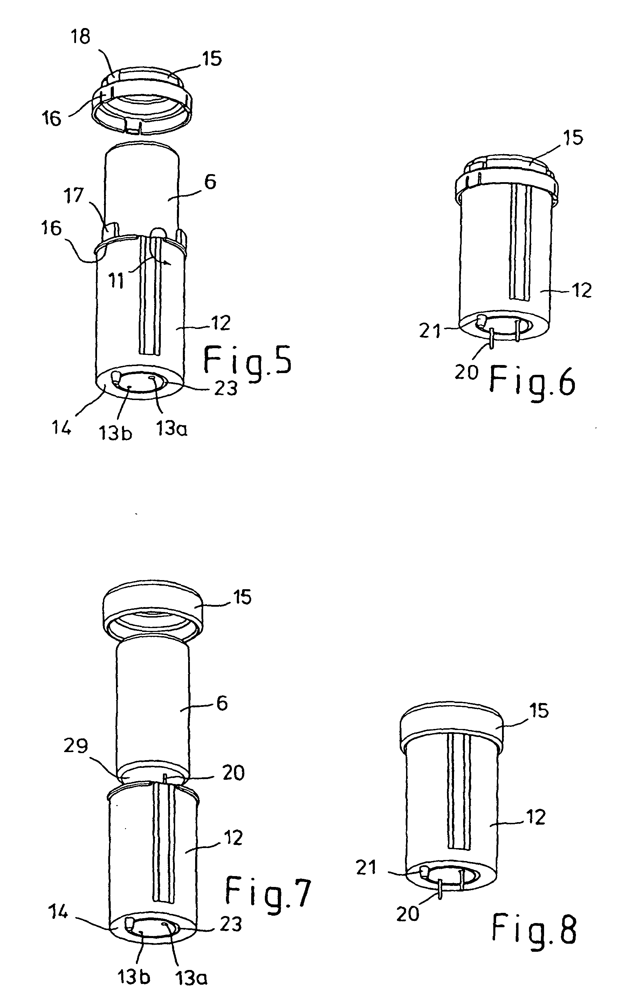

In einer bevorzugten, in den Figuren 5 bis 8 dargestellten Ausführungsform besteht der - insbesondere zylinderförmige - Schutzbecher 7 aus einem an der Leiterplatte 7 anliegenden Becherunterteil 12 mit einem Anschlussöffnungen 13a, 13b aufweisenden Becherboden 14 und einem Verschlussdeckel 15, der an dem Becherunterteil 12 form- und/oder kraftschlüssig befestigbar ausgeführt ist.

Bei der in den Figuren 5 und 6 gezeigten Ausführungsform, die eine erste Deckelvariante zeigt, besteht der Verschlussdeckel 15, wie das Becherunterteil 12, aus einem Thermo- oder Duroplast. Die Verbindung wird über Rastmittel 16 erreicht, wobei eine lageexakte Verrastung durch am Becherunterteil 12 auf seinem Randbereich angeformte - vorzugsweise drei - axiale Stege 17 und mit den Stegen 17 zusammenwirkende - vorzugsweise drei - Deckelöffnungen 18 erreicht wird.

Der Verschlussdeckel 15 kann aber auch, wie die Figuren 7 und 8 veranschaulichen (zweite Deckelvariante), aus einem Gummimaterial bestehen.

Durch diese zweiteilige Ausführungsform des erfindungsgemäßen Schutzbechers 7 kann trotz des nur teilweise mit Vergussmasse 10 umgossenen Becherunterteils 12 verhindert werden, dass Schmutz, Wasser, Feuchtigkeit oder Salznebel in einen Innenraum des Schutzbechers 7 eindringt.

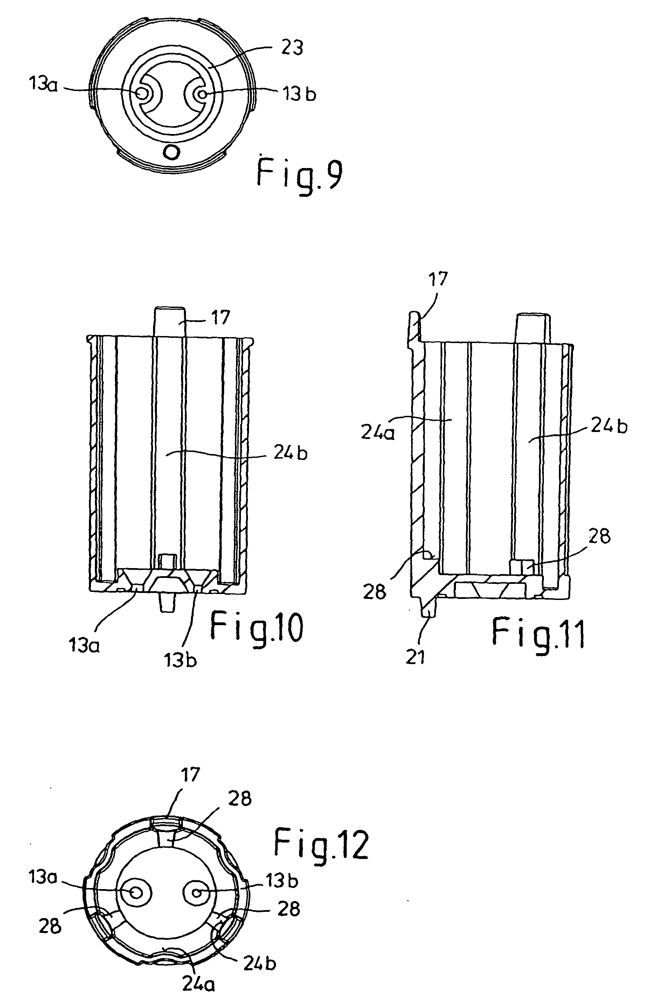

Wie an Hand der Figuren 9, 10 und 11 veranschaulicht ist, sind die Anschlussöffnungen 13a, 13b vorzugsweise unterschiedlich groß, und zwar derart, dass in Kombination mit unterschiedlichen Querschnitten von elektrischen Anschlüssen 20 des Elektrolytkondensators 6 (nicht dargestellt), dieser nur in einer einzigen Position vollständig in den Schutzbecher 7 eingeführt werden kann. Dadurch wird bei lageexakter Anordnung des Schutzbechers 7 in Bezug auf die Leiterplatte 4 ein Verpolschutz erreicht. Diese lageexakte Anordnung des Schutzbechers 7 wird dadurch erreicht, dass der Schutzbecher 7 an einer der Leiterplatte 4 zugewandten Außenseite ein Positionierungsmittel, insbesondere einen in die Leiterplatte 4 steckbaren Positionierungszapfen 21 (Fig. 3, Fig. 14) aufweist, so dass insbesondere in Kombination mit den unterschiedlichen Anschlussöffnungen 13a, 13b ein zuverlässiger Verpolschutz des Elektrolytkondensators 6 erreicht wird.

Für die Befestigung des Schutzbechers 7 an der Leiterplatte 4 ist an der der Leiterplatte 4 zugewandten Außenseite des Schutzbechers 7 eine zentrische Ringnut 23 für eine Kleberschicht, die insbesondere als Kleberraupe ausgebildet ist, vorhanden. Durch diese Ausbildung dient die Kleberschicht als Dichtung zwischen Schutzbecher 7 und Vergussmasse 10, so dass während des Gießens keine Vergussmasse durch die Anschlussöffnungen 13a, 13b in das Innere des Schutzbechers 7 eindringen kann. Außerdem verhindert sie einen Gasaustritt durch die Anschlussöffnungen 13a, 13b.

Es ist natürlich auch möglich, eine Gummidichtung oder ein im Bereich der Ringnut 23 angespritzes elastisches Zweikomponententeil als Dichtmittel zu verwenden, wobei die Befestigung des Schutzbechers 7 an der Leiterplatte 4 durch zusätzliche in den Zeichnungen nicht dargestellte Befestigungsmittel erfolgt.

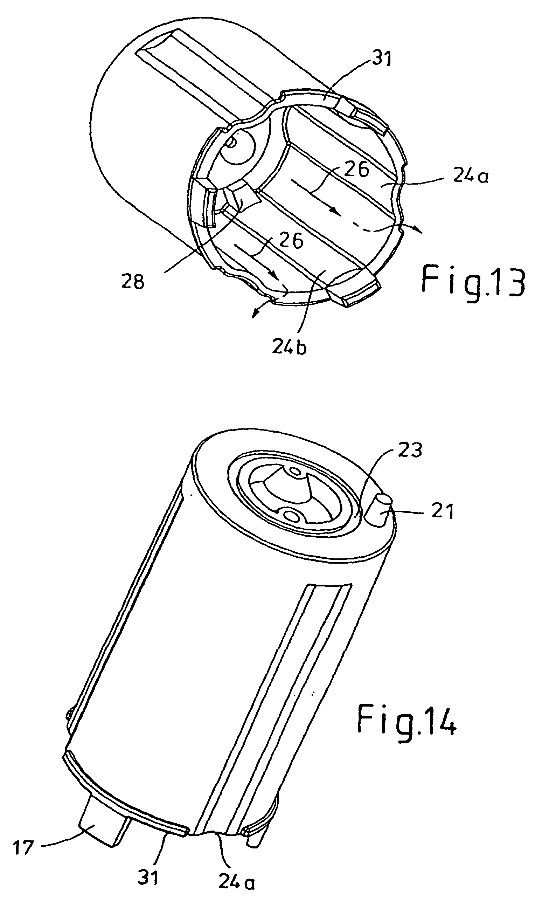

In einer bevorzugten Weiterbildung der Erfindung ist der Schutzbecher 7 mit insbesondere an seinem Innenumfang angeordneten und jeweils untereinander beabstandeten axialen Führungsstegen 24a und 24b versehen, die senkrecht zur Leiterplatte 4 angeordnet sind. Zwischen ihnen werden zweckmäßigerweise Gasaustrittswege 26 bzw. Gasführungskanäle (vgl. Fig. 4 und Fig. 13) gebildet. Die Führungsstege 24a und 24b sind insbesondere gewölbt, wobei der Führungssteg 24a zweckmäßigerweise durch Materaleinsenkungen an einer Zylindermantelfläche des Becherunterteils 12 geschaffen wird, wie z. B. Fig. 14 zeigt (Einbuchtungen, die auch in den Innenraum des Becherunterteils 12 übergehen). Der Führungssteg 24b geht in seinem Randbereich in den axialen Steg 17 über. Der Elektrolytkondensator 6 liegt bündig an den Führungsstegen 24a und 24b an, wie Fig. 3 zeigt, so dass eine vibrationssichere Anordnung und einfache Montage des Elektrolytkondensators gegeben ist.

Um die Montage, bzw. das Einführen der Anschlüsse 20 des Elektrolytkondensators 6 in die Leiterplatte 4 zu erleichtern, ist weiterhin bevorzugt vorgesehen, dass die Anschlussöffnungen 13a, 13b trichterartig ausgebildet sind.

Wie in Fig. 13 zu sehen ist, sind insbesondere bodenseitig an einer Innenfläche des Schutzbechers angeformte Anlagezapfen 28 vorhanden, die, wie Fig. 3 veranschaulicht, als Abstandhalter für den Elektrolytkondensator 6 dienen. Dadurch ist einerseits eine von der Leiterplatte 4 beabstandete Anordnung einer bodennahen Stirnseite 29 gegeben, so dass eventuell in das Innere des Schutzbechers 7 eingedrungene Vergussmasse unschädlich ist und andererseits die Stirnseite 29, insbesondere an Stellen einer Ausgasgummidichtung des Elektrolytkondensators 6 nicht gasdicht abgeschlossen wird. Bevorzugt besteht ein Abstand zur Leiterplatte 4 von etwa 5 mm, so dass auch bei relativ kurzen Anschlüssen 20 des Elektrolytkondensators 6 eine elektrische Verbindung möglich ist.

Wie einerseits die Figuren 3, 4 und 13 zeigen, ist das Becherunterteil 12 mit insbesondere einem Rastbund 31 versehen, der in den Bereichen der Führungsstege 24a jeweils unterbrochen ist. Der Verschlussdeckel 15 (Variante nach den Fig. 5 und 6) ist derart ausgebildet, dass er auf das Becherunterteil 12 übergestülpt werden kann.

Dadurch werden im Bereich der Führungsstege 24a zwischen dem Becherunterteil 12 und dem Verschlussdeckel 15, insbesondere schmale, spaltartige Öffnungen 32 für den Gasaustritt (vgl. Pfeile A, B) gebildet. Durch eine derart ausgebildete Öffnung 32 wird das Eintreten von z. B. Schmutz, Feuchtigkeit oder Salznebel weitgehend verhindert, wobei der Gasaustritt in den freien Bereich ungehindert möglich ist oder zumindest ein Druckabbau erfolgen kann.

An Hand der Fig. 4, 13, 5 und 3 wird in dieser Figuren-Reihenfolge der Gasweg zusammenfassend erläutert.

Die Gase 11 können aus dem Elektrolytkondensator 6 an seiner (unteren) Stirnseite 29 in den zwischen ihr und dem Becherboden gebildeten Raum entweichen (Fig. 4). Über die zwischen den Führungsstegen 24a und 24b und dem Elektrolytkondensator 6 gebildeten Kanäle (Gasaustrittswege 26) können die Gase 11 zum Verschlussdeckel 15 gelangen (Fig. 4 und 5). Im Bereich des Verschlussdeckels 15 gelangen die Gase nach einer Veränderung ihrer Bewegungsrichtung (Drehbewegung entlang des Verschlussdeckel-Innenumfangs) in den Bereich der Unterbrechungsstellen des Rastbundes 31 (Fig. 13 und 5). Anschließend treten sie aus der verwinkelten Öffnung 32 aus dem Schutzbecher 7 aus (Fig. 3, Pfeile A, B).

## Patentansprüche

1. Anordnung mit einer mindestens einen Kondensator (6), insbesondere Elektrolytkondensator, aufweisenden elektronischen Schaltung (1), die einen Bauteilträger (4) mit stromführenden Bahnen, insbesondere eine Leiterplatte, und eine den Kondensator (6) sowie den Bauteilträger (4) vor schädlichen Umgebungseinflüssen, wie Schmutz, Feuchtigkeit und/oder Salznebel, schützenden Vergussmasse (10) aufweist, wobei der Kondensator (6) mit den Leiterbahnen elektrisch verbunden ist,
**dadurch gekennzeichnet, dass** der Kondensator (6) in einem von der Vergussmasse (10) teilweise umschlossenen Schutzbecher (7) angeordnet ist, wobei der Schutzbecher (7) zwischen Kondensator (6) und Bauteilträger (4) angeordnet ist.

2. Anordnung nach Anspruch 1,
**dadurch gekennzeichnet, dass** die Vergussmasse (10) den Schutzbecher (7) nur derart teilweise umschließt, dass austretende Gase des Kondensators (6) von einem Vergussmassenbereich in einen freien Bereich entweichen können.

3. Anordnung nach Anspruch 1 oder 2,
**dadurch gekennzeichnet, dass** der Schutzbecher (7) aus einem an dem Bauteilträger (4) anliegenden Becherunterteil (12) mit einem Anschlußöffnungen (13a, 13b) aufweisenden Becherboden, insbesondere aus einem Thermo- oder Duroplast, und einem Verschlussdeckel (15), insbesondere aus einem Gummimaterial oder Thermo- oder Duroplast besteht, der an dem Becherunterteil form- und/oder kraftschlüssig befestigbar ausgeführt ist.

4. Anordnung nach den Ansprüchen 2 und 3,
**dadurch gekennzeichnet, dass** der Verschlussdeckel (15) und/oder das Becherunterteil (12) mindestens eine Öffnung aufweist und/oder mindestens eine zwischen dem Verschlussdeckel und dem Becherunterteil gebildete Öffnung (32) vorhanden ist, die derart ausgebildet ist (sind), dass sie gasdurchlässig aber wasser- und schmutzabweisend, insbesondere salznebelabweisend, ist (sind).

5. Anordnung nach Anspruch 3 oder 4,
**dadurch gekennzeichnet, dass** die Anschlußöffnungen (13a, 13b) derart unterschiedlich groß sind, dass ein Verpolschutz des Kondensators (6) erreicht wird, wobei der Kondensator (6) elektrische Anschlüsse (20) mit unterschiedlichen Querschnitten besitzt.

6. Anordnung nach einem der vorhergehenden Ansprüche,
**dadurch gekennzeichnet, dass** der Schutzbecher (7) zylinderförmig ausgebildet ist.

7. Anordnung nach einem der vorhergehenden Ansprüche,
**dadurch gekennzeichnet, dass** innerhalb des schutzbechers (7) senkrecht zum Bauteilträger (4) verlaufende Entgasungswege (26) vorhanden sind, die von einem boden- bzw. anschlussnahen Bereich des Kondensators (6) zu einem freien Bereich ausserhalb der Vergussmasse (10) führen.

8. Anordnung nach einem der vorhergehenden Ansprüche,
**dadurch gekennzeichnet, dass** der Schutzbecher (7) an einer dem Bauteilträger (4) zugewandten Außenseite ein Positionierungsmittel (21), insbesondere einen in den Bauteilträger (4) steckbaren, exzentrisch angeordneten Positionierungszapfen aufweist, der derart ausgeführt ist, dass zwangsweise eine korrekte Einbaulage des Schutzbechers (7) auf dem Bauteilträger (4), insbesondere eine polrichtige Lage, erreicht wird.

9. Anordnung nach einem der vorhergehenden Ansprüche,
**dadurch gekennzeichnet, dass** zwischen dem Schutzbecher (7) und dem Bauteilträger (4) ein Dichtmittel angeordnet ist.

10. Anordnung nach Anspruch 9,
**dadurch gekennzeichnet, dass** das Dichtmittel an einer dem Bauteilträger (4) zugewandten Außenseite des Schutzbechers (7) im Bereich eines an dem Bauteilträger (4) anliegenden Bodens des Schutzbechers angeordnet ist.

11. Anordnung nach Anspruch 10,
**dadurch gekennzeichnet, dass** das Dichtmittelauseiner abdichtenden Klebeschicht besteht.

12. Anordnung nach Anspruch 11,
**dadurch gekennzeichnet, dass** die Klebeschicht in einer Ringnut (23) angeordnet ist und insbesondere als Kleberraupe ausgebildet ist.

13. Anordnung nach einem der vorhergehenden Ansprüche,
**dadurch gekennzeichnet, dass** der Schutzbecher (7) Führungsmittel (24a, 24b) - insbesondere am Innenumfang des Schutzbechers angeordnete und jeweils untereinander beabstandete, vorzugsweise gewölbte, Führungsstege - für den Kondensator (6) aufweist.

14. Anordnung nach einem der vorhergehenden Ansprüche,
**dadurch gekennzeichnet, dass** der Schutzbecher (7) mindestens einen Abstandhalter (28) - insbesondere bodenseitig an einer Innenfläche des Schutzbechers angeformte Anlagezapfen - aufweist, der derart ausgebildet ist, dass einerseits eine von dem Bauteilträger (4) beabstandete Anordnung einer bodennahen Stirnseite (29) des Kondensator (6) gegeben ist und andererseits die Stirnseite, insbesondere an Stellen einer Ausgasgummidichtung des Kondensators (6) nicht gasdicht abgeschlossen wird.

15. Anordnung nach Anspruch 14,
**dadurch gekennzeichnet, dass** dieAbstandhalter(27)derart bemessen sind, dass die bodennahe Stirnseite (29) des Kondensators um etwa 5 mm von einer Anschlussebene des Bauteilträgers (4) beabstandet angeordnet ist.

16. Anordnung nach einem der Ansprüche 8 bis 15,
**dadurch gekennzeichnet, dass** das Becherunterteil (12) auf einem deckelzugewandten Randbereich - vorzugsweise drei - angeformte axiale Stege (17) aufweist, die mit - vorzugsweise drei - Deckelöffnungen (18) zusammenwirken.

17. Anordnung nach einem der vorhergehenden Ansprüche,
**gekennzeichnet durch** ein schalenartiges, die Vergussmasse (10) aufnehmendes Becherteil (9).

## Claims

1. An assembly having an electronic circuit (1) which has at least one capacitor (6), in particular an electrolytic capacitor, and a component carrier (4) having current-carrying conductors, in particular a printed circuit-board and a casting compound (10) protecting the capacitor (6) and the component carrier (4) from harmful environmental influences such as dirt, moisture and/or saline fog, the capacitor (6) being electrically connected to the circuit-board conductors, **characterised in that** the capacitor (6) is arranged in a protective cup (7) which is partially surrounded by the casting compound (10), the protective cup (7) being arranged between the capacitor (6) and the component carrier (4).

2. An assembly according to Claim 1, **characterised in that** the casting compound (10) surrounds the protective cup (7) only partially, in such a way that the gases exiting from the capacitor (6) can escape from a casting compound region into a free region.

3. An assembly according to Claim 1 or 2, **characterised in that** the protective cup (7) comprises a cup underpart (12), which abuts against the component carrier (4) and has a cup base, which has connecting openings (13a, 13b) and is made particularly from a thermoplastic or duroplastic material, and a closing cover (15), which is made particularly from a rubber material or a thermoplastic or duroplastic material and is constructed such that it may be fixed to the cup underpart with form fit and/or force fit.

4. An assembly according to Claims 2 and 3, **characterised in that** the closing cover (15) and/or the cup underpart (12) has/have at least one opening, and/or there is at least one opening (32) formed between the closing cover and the cup underpart, which opening(s) is/are constructed such that it/they is/are gas permeable but water-repellent and dirt-repellent, particularly resistant to saline fog.

5. An assembly according to Claim 3 or 4, **characterised in that** the connecting openings (13a, 13b) are of different sizes such that a polarisation of the capacitor (6) is achieved, the capacitor (6) having electrical connections (20) with different cross-sections.

6. An assembly according to one of the preceding claims, **characterised in that** the protective cup (7) is of a cylindrical construction.

7. An assembly according to one of the preceding claims, **characterised in that** degassing channels (26) extending perpendicularly to the component carrier (4) within the protective cup (7) are present, which lead from a region of the capacitor (6) in the vicinity of the base or connection to a free region outside the casting compound (10).

8. An assembly according to one of the preceding claims, **characterised in that**, on an outer side facing the component carrier (4), the protective cup (7) has a positioning means (21), particularly an eccentrically arranged positioning pin, which can be pushed into the component carrier (4) and is constructed such that a correct installation position of the protective cup (7) on the component carrier (4), particularly a correct pole position, is necessarily achieved.

9. An assembly according to one of the preceding claims, **characterised in that** a sealing means is arranged between the protective cup (7) and the component carrier (4).

10. An assembly according to Claim 9, **characterised in that** the sealing means is arranged on an outer side, facing the component carrier (4), of the protective cup (7) in the region of a base of the protective cup, which base abuts against the component carrier (4).

11. An assembly according to Claim 10, **characterised in that** the sealing means comprises a sealing adhesive layer.

12. An arrangement according to Claim 11, **characterised in that** the adhesive layer is arranged in an annular groove (23) and is constructed in particular as an adhesive bead.

13. An arrangement according to one of the preceding claims, **characterised in that** the protective cup (7) has guide means (24a, 24b) - particularly preferably curved guide webs arranged on the inner circumference of the protective cup and at a respective mutual spacing - for the capacitor (6).

14. An arrangement according to one of the preceding claims, **characterised in that** the protective cup (7) has at least one spacer (28) - particularly a contact pin integrally formed on an inside face of the protective cup on the base side - which is constructed such that, on the one hand, an end face (29) of the capacitor (6) is arranged spaced from the component carrier (4) and, on the other, the end face is not sealed in gas-tight manner, particularly at points of an outgassing rubber seal of the capacitor (6).

15. An arrangement according to Claim 14, **characterised in that** the spacers (27) are dimensioned such that that end face (29) of the capacitor which is near to the base is arranged at a spacing of approximately 5 mm from a connecting plane of the component carrier (4).

16. An arrangement according to one of Claims 8 to 15, **characterised in that**, on an edge region facing the cover, the cup underpart (12) has - preferably three - integrally formed axial flanges (17) which cooperate with - preferably three - cover openings (18).

17. An arrangement according to one of the preceding claims, **characterised by** a shell-like cup part (9) receiving the casting compound (10).

## Revendications

1. Agencement avec un circuit électronique (1) comportant au moins un condensateur (6), en particulier un condensateur électrolytique qui présente un support de composant (4) avec des circuits conducteurs, en particulier une carte imprimée et une masse de scellement (10) de protection du condensateur (6) et du support de composant (4) contre les influences environnementales nocives telles qu'impuretés, humidité et/ou brouillard salin, le condensateur (6) étant relié électriquement aux pistes conductrices,
**caractérisé en ce que** le condensateur (6) est disposé dans un boîtier de protection (7) partiellement entouré de la masse de scellement (10), le boîtier de protection (7) étant disposé entre le condensateur (6) et le support de composant (4).

2. Agencement selon la revendication 1,
**caractérisé en ce que** la masse de scellement (10) n'entoure que partiellement le boîtier de protection (7) de telle sorte que les gaz se dégageant du condensateur (6) peuvent s'échapper de la zone de la masse de scellement dans une zone libre.

3. Agencement selon l'une quelconque des revendications 1 ou 2,
**caractérisé en ce que** le boîtier de protection (7) est constitué d'un corps de boîtier (12) s'appuyant sur le support de composant (4), avec un fond de boîtier présentant des ouvertures de raccordement (13a, 13b), en particulier en matière thermoplastique ou thermodurcie, et d'un couvercle d'obturation (15), en particulier dans un matériau à base de caoutchouc ou dans une matière thermoplastique ou thermodurcie, pouvant être fixé sur le corps du boîtier par une liaison en complémentarité de forme et/ou en force.

4. Agencement selon l'une quelconque des revendications 2 ou 3,
**caractérisé en ce que** le couvercle d'obturation (15) et/ou le corps du boîtier (12) présente au moins une ouverture et/ou **en ce qu'**au moins une ouverture (32) est formée entre le couvercle d'obturation et le corps de boîtier, qui est (sont) formée(s) de sorte qu'elle(s) laisse(nt) passer le gaz mais repousse(nt) l'eau et les impuretés, en particulier le brouillard salin.

5. Agencement selon l'une quelconque des revendications 3 ou 4,
**caractérisé en ce que** les ouvertures de raccordement (13a, 13b) ont une taille différente de manière à obtenir une protection contre l'inversion de polarité du condensateur (6), le condensateur (6) étant pourvu de raccordements électriques (20) de différentes sections.

6. Agencement selon l'une quelconque des revendications précédentes,
**caractérisé en ce que** le boîtier de protection (7) a la forme d'un cylindre.

7. Agencement selon l'une quelconque des revendications précédentes,
**caractérisé en ce qu'**à l'intérieur du boîtier de protection (7) existent des voies de dégazage (26) disposés perpendiculairement au support de composant (4) qui mènent d'une zone voisine du fond ou du raccordement du condensateur (6) vers une zone libre à l'extérieur de la masse de scellement (10).

8. Agencement selon l'une quelconque des revendications précédentes,
**caractérisé en ce que** le boîtier de protection (7) présente sur l'une des face extérieure orientée vers le support de composant (4), un moyen de positionnement (21), en particulier un ergot de positionnement, disposé de manière excentrée, enfichable dans le support de composant (4), conçu de manière à obtenir une position de montage obligatoirement correcte du boîtier de protection (7) sur le support de composant (4), en particulier une position correcte du pôle.

9. Agencement selon l'une quelconque des revendications précédentes,
**caractérisé en ce qu'**un moyen d'étanchéité est disposé entre le boîtier de protection (7) et le support de composant (4).

10. Agencement selon la revendication 9,
**caractérisé en ce que** le moyen d'étanchéité est disposé sur un côté extérieur du boîtier de protection (7) orienté vers le support de composant (4), dans la zone d'un fond de boîtier de protection, appuyé contre le support de composant (4).

11. Agencement selon la revendication 10,
**caractérisé en ce que** le moyen d'étanchéité se compose d'une couche adhésive assurant l'étanchéité.

12. Agencement selon la revendication 11,
**caractérisé en ce que** la couche adhésive est disposée dans une rainure annulaire (23) et est de préférence conformée en chenille adhésive.

13. Agencement selon l'une quelconque des revendications précédentes,
**caractérisé en ce que** le boîtier de protection (7) présente des moyens de guidage (24a, 24b) pour le condensateur (6) - en particulier des traverses de guidage disposées sur la périphérie intérieure du boîtier de protection, de préférence bombées et espacées entre elles-.

14. Agencement selon l'une quelconque des revendications précédentes,
**caractérisé en ce que** le boîtier de protection (7) présente au moins une entretoise (28) - en particulier côté fond, un goujon d'appui formé sur une face intérieure du boîtier de protection - conçue de sorte que d'une part, un agencement espacé du support de composant (4) constitue la face frontale (29) à proximité du fond du condensateur (6) et que d'autre part, la face frontale ne soit pas fermée de manière étanche aux gaz, en particulier aux emplacements du joint en caoutchouc pour l'échappement des gaz du condensateur (6).

15. Agencement selon la revendication 14,
**caractérisé en ce que** les entretoises (27) sont calibrées de manière à ce que la face frontale (29) à proximité du fond du condensateur soit espacée d'environ 5 mm d'une extrémité de raccordement du support de composant (4).

16. Agencement selon l'une quelconque des revendications 8 à 15,
**caractérisé en ce que** le corps de boîtier (12) présente, formées sur la zone périphérique orientée vers le couvercle, - de préférence trois - traverses axiales (17) coopérant avec - de préférence trois - ouvertures de couvercle (18).

17. Agencement selon l'une quelconque des revendications précédentes,
**caractérisé en** une partie de boîtier (9) en forme de bac accueillant la masse de scellement (10).
